Europäisches Patentamt

European Patent Office

Office européen des brevets

(11) Veröffentlichungsnummer: **0 609 536 A2**

## (12) EUROPÄISCHE PATENTANMELDUNG

(21) Anmeldenummer: **93120324.4**

(22) Anmeldetag: **16.12.93**

(51) Int. Cl.5: **H01L 21/336**, H01L 29/784

(30) Priorität: **14.01.93 DE 4300806**

(43) Veröffentlichungstag der Anmeldung:
**10.08.94 Patentblatt 94/32**

(84) Benannte Vertragsstaaten:
**DE FR GB IT**

(71) Anmelder: **SIEMENS AKTIENGESELLSCHAFT**
**Wittelsbacherplatz 2**
**D-80333 München(DE)**

(72) Erfinder: **Dipl.-Phys. Oppermann,**
**Klaus-Günther**
**Schützenstrasse 27**
**D-83607 Holzkirchen(DE)**
Erfinder: **Dr. Rösner, Wolfgang**
**Heinzelmännchenstrasse 2**
**D-81739 München(DE)**
Erfinder: **Dr. Hofmann, Franz**
**Ehring 6**
**D-93104 Sünching(DE)**

(54) **Verfahren zur Herstellung von vertikalen MOS-Transistoren.**

(57) Zur Herstellung von vertikalen MOS-Transistoren werden in einem Substrat (1) dotierte Gebiete für Drain (11), Wanne (3) und Source (4) in vertikaler Reihenfolge gebildet. Senkrecht zur Oberfläche des Substrats (1) werden unter Verwendung einer $Si_3N_4$-Maske (5) Gräben (6) geätzt, die Source (4) und Wanne (3) durchtrennen, die mit dotiertem Polysilizium gefüllt werden und die im oberen Bereich durch lokale Oxidation selbstjustiert mit einer Isolationsstruktur (8) verschlossen werden. Die Isolationsstruktur (8) überragt die Gräben (6) seitlich. Unter Verwendung der Isolationsstruktur (8) als Ätzmaske werden zwischen benachbarten Gräben (6) Kontaktlöcher (9) bis in die Wanne (3) geöffnet, die mit einer Metallisierung zur Kontaktierung von Source (4) und Wanne (3) versehen werden.

FIG 6

EP 0 609 536 A2

Eine entscheidende Kenngröße von Leistungstransistoren ist der auf einer vorgegebenen Fläche $F_{Si}$ erreichbare Einschaltwiderstand $R_{DS(on)}$. Bei der Optimierung eines Bauelementes bezüglich Bauelementfläche und damit Kosten muß bei vorgegebenem Gesamtwiderstand des Bauelementes der spezifische Einschaltwiderstand $R_{DS(on)} * F_{Si}$ minimiert werden. Im Spannungsbereich unter 50 Volt, der insbesondere für Anwendungen in der Automobiltechnik von Bedeutung ist, läßt sich der spezifische Einschaltwiderstand durch Verkleinerung der Fläche der MOS-Zelle verringern.

Es ist bekannt (s. z. B. D. Ueda et al, IEEE Vol. ED-34, 1987, S. 926-930; H.-R. Chang et al, IEEE Vol. ED-36, 1989, S. 1824-1829; K. Shenai, IEEE Ed Lett. Vol. 12, 1991, S. 108-110) zur Verkleinerung des Flächenbedarfs der MOS-Zelle, einen MOS-Transistor vertikal aufzubauen. Die dabei erreichbare Verringerung des Platzbedarfs hängt von der maximalen Strukturfeinheit ab, die bei Herstellverfahren erzielbar ist.

In den verikalen MOS-Transistoren werden an der Oberfläche eines Siliziumsubstrats Sourcegebiete, die z. B. n-dotiert sind, und Wannengebiete, die z. B. p-dotiert sind mit einem ohmschen Kontakt miteinander verbunden. Der ohmsche Kontakt wird über eine Metallisierung an der Oberfläche realisiert. Die Gateelektrode wird in den vertikalen MOS-Transistoren in einem Graben angeordnet, der senkrecht zur Oberfläche des Substrats verläuft. Das Draingebiet wird unterhalb von Sourcegebiet und Wanne im Substrat realisiert.

Aus D. Ueda et al, IEEE Vol. ED-34, 1987, S. 926-930 ist bekannt, in einem Verfahren zur Herstellung eines Leistungs-MOSFETs eine Siliziumscheibe zu verwenden, die z. B. n+-dotiert ist und an deren Oberfläche eine n⁻-dotierte Epitaxieschicht erzeugt wurde. Durch Implantation über eine Maske wird in der Oberfläche dieses Substrats eine p-dotierte Schicht gebildet, die die Wanne bildet. Durch Implantation unter Verwendung einer weiteren Maske werden in der Oberfläche streifenförmige Sourcegebiete, die n+-dotiert sind und die parallel zueinander verlaufen, erzeugt. Zwischen jeweils zwei benachbarten streifenförmigen Sourcegebieten verläuft an der Oberfläche des Substrats ein Teil der p-dotierten Wanne. Mit Hilfe einer Nitrid-Maske werden senkrecht zum Verlauf der streifenförmigen Sourcegebiete rechteckige Gräben erzeugt, die bis in die n⁻-dotierte Epitaxieschicht hineinreichen. Die Gräben sind ebenfalls in Form paralleler Streifen angeordnet, die einen rechten Winkel mit den Streifen der Sourcegebiete bilden. Die Gräben werden nach Herstellung eines Gatedielektrikums mit Polysilizium gefüllt. Das Polysilizium wird zurückgeätzt, wobei die Kontaktfläche für den MOS-Gate-Kontakt mit einer vierten Maske abgedeckt werden muß. Durch lokale Oxidation wird Polysilizium im oberen Bereich der Gräben zu $SiO_2$ umgebildet. Nach Entfernen von einer zur Grabenätzung und zur lokalen Oxidation verwendeten $Si_3N_4$-Maske und Öffnung des Kontaktloches auf die MOS-Gate-Kontaktfläche wird eine Aluminium-Metallisierung aufgebracht, die die Sourcegebiete und die p-dotierten Wannengebiete kontaktiert.

Die an die Oberfläche des Substrats reichenden Teile der p-dotierten Wanne müssen eine Ausdehnung aufweisen, die mindestens der Mindestkontaktfläche entspricht. Dies gilt für die n-dotierten Source-Gebiete ebenso. Damit ist ein minimaler Platzbedarf an der Scheibenoberfläche verbunden.

In den in dieser Weise an der Oberfläche des Substrats abwechselnd angeordneten n+-dotierten Sourcegebieten und p-dotierten Wannengebieten kann es darüberhinaus wegen der großen Abstände zu parasitären Bipolareffekten kommen.

Der Erfindung liegt das Problem zugrunde, ein weiteres selbstjustiertes Verfahren zur Herstellung von vertikalen MOS-Transistoren anzugeben, mit dem Bipolareffekte in einem auf diese Weise hergestellten MOS-Transistorfeld vermieden werden und das darüberhinaus mit einer Maske weniger auskommt. Das Verfahren soll insbesondere geeignet sein, zusätzlich den Source-Kontakt vertikal im Bauelement zu erzeugen.

Dieses Problem wird erfindungsgemäß gelöst durch ein Verfahren nach Anspruch 1. In dem erfindungsgemäßen Verfahren werden in einem Substrat aus Silizium in vertikaler Reihenfolge Gebiete für Drain, Wanne und Source gebildet. Unter Verwendung einer $Si_3N_4$-Maske werden, die durch ein abgeschiedenes Oxid verstärkt sein kann, im wesentlichen senkrecht zur Oberfläche des Substrats Gräben geätzt. Die Gräben werden in eine solche Tiefe geätzt, daß sie Source und Wanne durchtrennen. Die Oberfläche der Gräben wird mit einem Gatedielektrikum versehen. Die Gräben werden dann mit dotiertem Polysilizium aufgefüllt. Durch lokale Oxidation wird anschließend im oberen Bereich jedes Grabens eine Isolationsstruktur erzeugt, die das Polysilizium im jeweiligen Graben vollständig bedeckt und die den Graben seitlich überragt. Nach Entfernen der $Si_3N_4$-Maske wird unter Verwendung der Isolationsstruktur als Ätzmaske jeweils zwischen benachbarten Gräben ein Kontaktloch geätzt, daß bis in die Wanne hineinreicht. Mindestens die Oberfläche der Kontaktlöcher wird zur Kontaktierung von Source und Wanne mit einer Metallisierung versehen.

Über die Dicke des entstehenden $SiO_2$ bei der lokalen Oxidation wird eingestellt, in welchem Ausmaß die Isolationsstruktur den Graben seitlich überragt. Über die Ätzzeit wird eingestellt, wie tief das Kontaktloch in die Wanne hinein reicht. Die Kontaktierung von Source und Wanne erfolgt daher

selbstjustiert zur $Si_3N_4$-Maske. Damit kann der Abstand benachbarter Gräben und damit die pro MOS-Zelle benötigte Fläche drastisch reduziert werden.

Durch Verwendung einer Siliziumscheibe, die eine hohe Dotierstoffkonzentration aufweist und an deren Oberfläche eine Epitaxieschicht mit einer geringeren Dotierstoffkonzentration desselben Leitfähigkeitstyp angeordnet ist, können ein dotiertes Gebiet für die Wanne und für das Sourcegebiet durch Implantation durch ein und dieselbe Maske, die z. B. aus $SiO_2$ hergestellt wird, gebildet werden.

Vorzugsweise sind die Gräben Teil einer zusammenhängenden Grabenstruktur, in der im wesentlichen parallel zur Oberfläche des Substrats verlaufende Gräben mit quer dazu verlaufende Graben rasterförmig angeordnet sind. In dieser Grabenstruktur werden viereckige Oberflächenelemente des Siliziumsubstrats definiert, die an allen vier Seiten von Grabenelementen begrenzt sind. Auf diese Weise werden MOS-Zellen gebildet, die auf allen vier Seiten selbstjustiert von der Gateelektrode und der an deren Oberfläche angeordneten Isolationsstruktur umgeben sind. Die Gräben sind alle miteinander verbunden, so daß die Gateelektrode über einen einzigen Kontakt anschließbar ist.

Zum Füllen der Gräben wird insbesondere ganzflächig eine leitfähige Polysiliziumschicht aufgebracht, die z. B. durch Ausdiffusion aus einer dotierten Phosphorglasschicht dotiert wird. Anschließend wird die Polysiliziumschicht zurückgeätzt, wobei die Oberfläche der $Si_3N_4$-Maske freigelegt wird. Vor dem Rückätzen der Polysiliziumschicht ist es vorteilhaft, eine Maske zu erzeugen, die ein zusammenhängendes Flächenelement der Polysiliziumschicht abdeckt, das sich über mehrere benachbarte Gräben erstreckt. Beim Rückätzen der Polysiliziumschicht bleibt in diesem Bereich eine Polysiliziumfläche erhalten. Diese wird bei der lokalen Oxidation an der Oberfläche oxidiert. Auf diese Polysiliziumfläche kann später ein Kontaktloch geöffnet werden, über das ein Kontakt zu der zusammenhängenden Gateelektrode gebildet wird. Dadurch kann der Kontakt zur Gateelektrode auch in Fällen, in denen die Grabenbreite und damit die Breite der Gateelektrode sehr gering ist, ohne Schwierigkeiten hergestellt werden

Es liegt im Rahmen der Erfindung, vor dem Aufbringen der Metallisierung in die Oberfläche der Kontaktlöcher Dotierstoff von demselben Leitfähigkeitstyp wie die Wanne einzubringen. Auf diese Weise wird der Kontaktwiderstand zur Wanne verbessert. Außerdem führt diese Kontaktlochimplantation zu einer Veränderung der Wannenstruktur. Damit kann der Ort der maximalen Feldstärke bei einem Avalanche-Durchbruch vom Graben, und damit dem Gatedielektrikum, weg in das Volumen hinein verschoben werden.

Durch vollständiges Auffüllen der Kontaktlöcher mit der Metallisierung wird eine planare Struktur erzielt.

Es liegt im Rahmen der Erfindung, das Draingebiet durch ein tiefreichendes Anschlußgebiet von der Oberfläche des Substrats her zu kontaktieren. Dabei kann das Draingebiet sowohl die ursprüngliche Siliziumscheibe mit entsprechender Dotierung als auch eine vergrabene Schicht im Substrat sein. Diese Ausführungsform der Erfindung macht den nach dem Verfahren hergestellten MOS-Transistor integrierbar.

Weitere Ausgestaltungen der Erfindung gehen aus den übrigen Ansprüchen hervor.

Im weiteren wird die Erfindung anhand der Figuren und eines Ausführungsbeispiels näher erläutert.

Fig. 1     zeigt die Herstellung einer Wanne unter Verwendung einer Maske.

Fig. 2     zeigt die Herstellung eines Sourcegebietes unter Verwendung derselben Maske.

Fig. 3     zeigt die Herstellung von Gräben unter Verwendung einer $Si_3N_4$-Maske.

Fig. 4     zeigt das Auffüllen der Gräben mit Polysilizium.

Fig. 5     zeigt die Herstellung von Isolationsstrukturen durch lokale Oxidation.

Fig. 6     zeigt die Herstellung von Kontaktlöchern unter Verwendung der Isolationsstruktur als Ätzmaske.

Fig. 7     zeigt die Öffnung eines Kontaktlochs zu der Gateelektrode.

Fig. 8     zeigt das Einbringen von Metallisierung in die Kontaktlöcher.

Fig. 9     zeigt einen Ausschnitt aus einem Zellenfeld, das nach dem erfindungsgemäßen Verfahren hergestellt wurde.

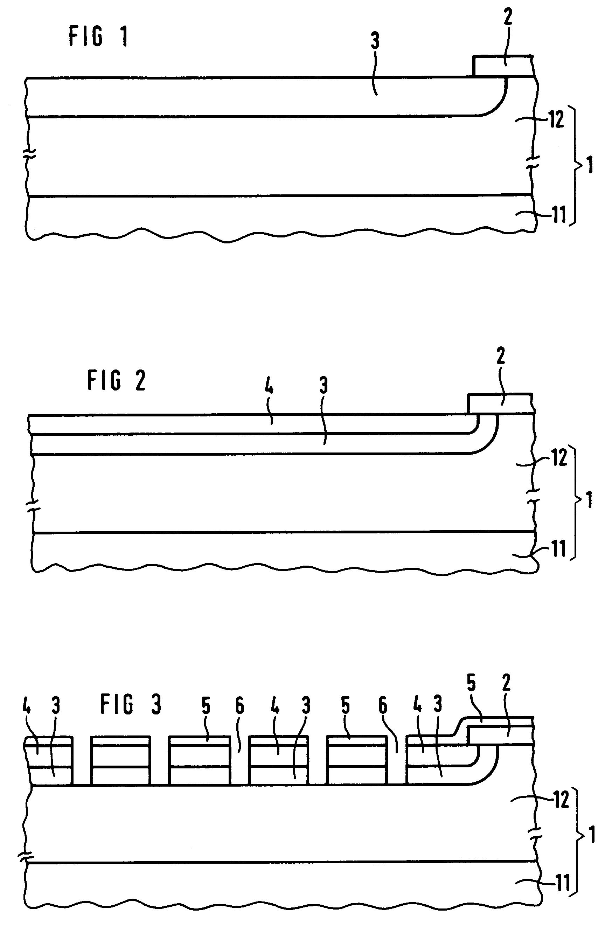

Auf eine hochdotierte, z. B. $n^+$-dotierte Siliziumscheibe 11 wird eine z. B. 5 $\mu$m dicke n-dotierte Epitaxieschicht 12 abgeschieden. Die Siliziumscheibe 11 weist eine Dotierstoffkonzentration von z. B. $1 \times 10^{19}$ cm$^{-3}$, die Epitaxieschicht 12 weist eine Dotierstoffkonzentration von z. B. $10^{16}$ cm$^{-3}$ auf. Die Siliziumscheibe 11 und die Epitaxieschicht 12 bilden gemeinsam ein Substrat 1 (s. Fig. 1).

Auf die Oberfläche des Substrats 1 wird eine z. B. 800 nm dicke $SiO_2$-Schicht abgeschieden, die mit Hilfe einer ersten Fototechnik als Maske 2 strukturiert wird. Durch Implantation und Eintreiben von Bor unter Verwendung der Maske 2 als Implantationsmaske wird eine p-dotierte Wanne 3 gebildet. Anschließend wird unter Verwendung derselben Maske 2 als Implantationsmaske eine Arsenimplantation und ein weiterer Eintreibschritt durchgeführt. Dadurch wird ein Sourcegebiet 4 (s. Fig. 2) gebildet. Das Sourcegebiet 4 weist eine Dotierstoff-konzentration von z. B. $C_s$ = 1 x $10^{20}$ $cm^{-3}$ auf. Die Wanne 3 weist eine Dotierstoffkonzentration von $C_s$ = 5 x $10^{16}$ $cm^{-3}$ auf.

Anschließend wird ganzflächig eine $Si_3N_4$-Schicht abgeschieden und strukturiert, so daß eine $Si_3N_4$-Maske 5 entsteht (s. Fig. 3). Unter Verwendung der $Si_3N_4$-Maske 5 als Ätzmaske wird eine Grabenätzung durchgeführt. Dabei entstehen Gräben 6, die das Sourcegebiet 4 und die Wanne 3 durchtrennen und die bis in die Epitaxieschicht 12 hineinreichen. Die Gräben 6 bilden parallel zur Oberfläche des Substrats 1 eine rasterförmige Grabenstruktur, in der z. B. jeweils vier Gräben eine viereckige Fläche, die von den vier Gräben begrenzt ist, definieren.

Die Ätzung der Gräben erfolgt z. B. durch Trockenätzung mit HBr, He, $O_2$, $NF_3$.

An der Oberfläche der Gräben wird z. B. durch Oxidation ein Gatedielektrikum aus $SiO_2$ hergestellt (nicht dargestellt).

Anschließend wird ganzflächig eine Polysi-ziumschicht abgeschieden und dotiert. Die Dotierung erfolgt z. B. durch Ausdiffusion aus einer darüber abgeschiedenen dotierten Phosphorglasschicht.

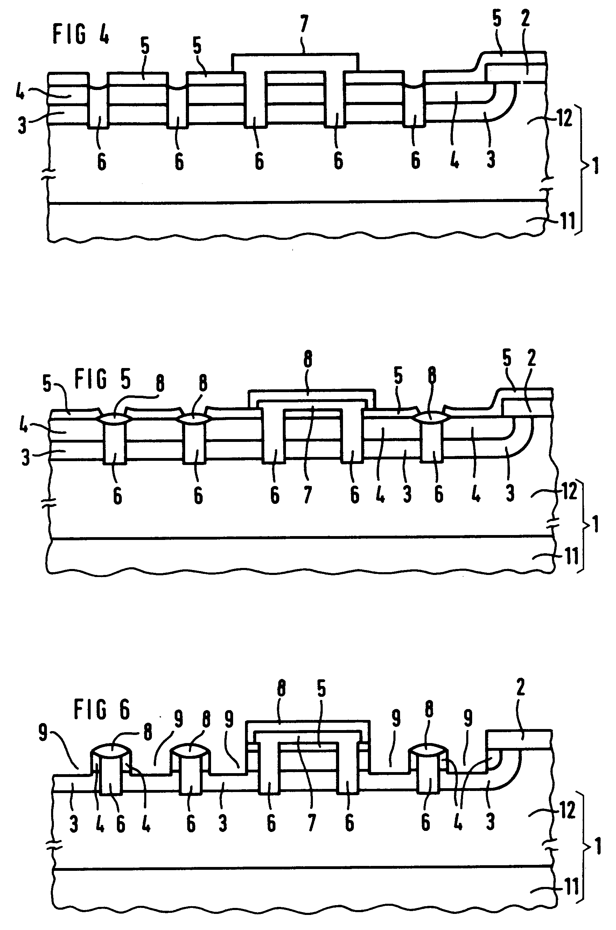

Es wird eine Fotolackmaske (nicht dargestellt) gebildet, die z. B. zwei benachbarte Gräben und ein dazwischen angeordnetes, zusammenhängen-des Polysiliziumgebiet abdeckt. Durch Trockenät-zen (HBr, $Cl_2$, $C_2F_6$) wird die Polysiliziumschicht ruckgeätzt, so daß die Gräben 6 bis an die Oberfläche des Sourcegebietes 4 mit Polysilizium gefüllt bleiben. Das unter der Fotolackmaske angeordnete Polysiliziumgebiet verbleibt dabei an der Oberfläche der beiden benachbarten Gräben 6, sowie dem zwischen beiden angeordneten Teil der $Si_3N_4$-Maske 5. Es entsteht auf diese Weise ein beide Gräben überdeckender Polysiliziumsteg 7 (s. Fig. 4).

Nach Entfernung der Fotolackmaske wird in einer thermischen Oxidation lokal das freiliegende Polysilizium oxidiert, wobei eine Isolationsstruktur 8 entsteht. Die Isolationsstruktur 8 umfaßt linsenförmige Elemente, die jeweils im oberen Bereich eines Grabens angeordnet sind. Diese linsenförmigen Elemente der Isolationsstruktur 8 überragen dabei den jeweiligen Graben seitlich. Die Länge des Überragens wird über die Dicke des linsenförmigen Elementes und damit über die Dauer der lokalen Oxidation eingestellt. An der Oberfläche des Polysiliziumsteges 7 umfaßt die Isolationsstruk-tur einen $SiO_2$-Steg.

Unter Verwendung der Isolationsstruktur 8 als Ätzmaske werden Kontaktlöcher 9 gebildet, die bis in die Wanne 3 hineinreichen. Die Kontaktlöcher 9 durchtrennen dabei die Sourcegebiete 4. Die Ätzung erfolgt z. B. mit HBr, Ne, $O_2$, $NF_3$. Die Weite

der Kontaktlöcher 9 wird über die Dicke der linsenförmigen Oxidstrukturen eingestellt.

Zur Verbesserung des Kontaktwiderstandes der Wanne 3 kann anschließend eine Kontaktlochimplantation mit Bor durchgeführt werden. Dabei wird in der Oberfläche des Kontaktloches 9 die Borkonzentration in der Wanne 3 erhöht. Dieses fuhrt auch zu einer Veränderung der p-Wannenstruktur, die sich auf das Schaltverhalten des Bauelementes günstig auswirkt.

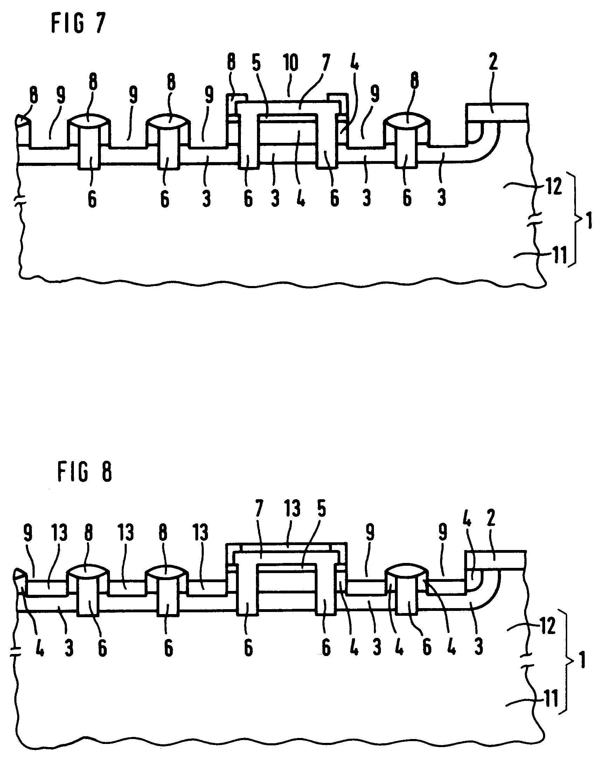

Mit einer weiteren Fototechnik (nicht dargestellt) wird oberhalb des Polysiliziumsteges 7 ein weiteres Kontaktloch 10 zu dem Polysiliziumsteg 7 geöffnet (s. Fig. 7).

Schließlich werden in den Kontaktlöchern 9 und in dem Kontaktloch 10 Metallisierungen 13 erzeugt. Die Metallisierungen 13 in den Kontaktlöchern 9 bilden einen Kontakt zwischen dem jeweiligen Sourcegebiet 4 und der Wanne 3. Sie bestehen z. B. aus Ti/TiN und Aluminium.

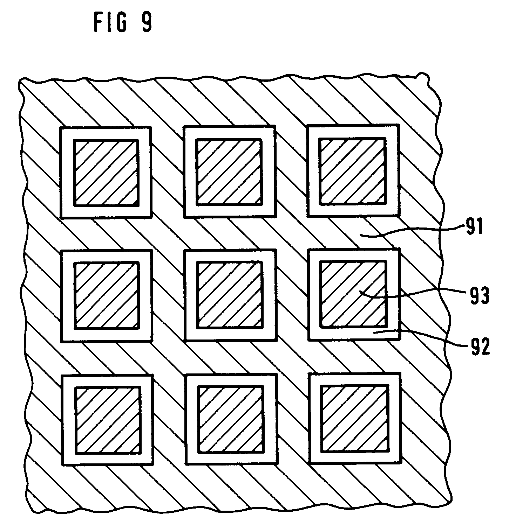

Fig. 9 zeigt einen Ausschnitt aus einem MOS-Zellenfeld, das nach dem erfindungsgemäßen Verfahren hergestellt wurde. Solche Zellenfelder haben in typischen Anwendungen 6,25 x $10^6$ Elemente pro $cm^2$. In dem Zellenfeld sind die Gräben Teil einer Grabenstruktur 91, die viereckige Flächenelemente definiert. Jedes der viereckigen Flächenelemente ist dabei vollständig von vier Gräben umgeben. Die Grabenstruktur 91 ist mit dotiertem Polysilizium aufgefüllt. Jedes der Flächenelemente umfaßt entlang der Kante der Grabenstruktur 91 ein Sourcegebiet 92 auf der der Grabenstruktur 91 abgewandten Seite ist das Sourcegebiet 92 jeweils durch einen Kontakt 93 begrenzt, der ein Kontaktloch auffüllt. Jedes der Flächenelemente nimmt eine MOS-Zelle auf.

**Patentansprüche**

1. Verfahren zur Herstellung von vertikalen MOS-Transistoren,
   - bei dem in einem Substrat (1) aus Silizium dotierte Gebiete für Drain (11), Wanne (3) und Source (4) in vertikaler Reihenfolge gebildet werden,
   - bei dem unter Verwendung einer $Si_3N_4$-Maske (5) im wesentlichen senkrecht zur Oberfläche des Substrats (1) Gräben (6) geätzt werden, die Source (4) und Wanne (3) durchtrennen,
   - bei dem die Oberfläche der Gräben (6) mit einem Gatedielektrikum versehen wird und die Gräben (6) mit dotiertem Polysilizium aufgefüllt werden,
   - bei dem durch lokale Oxidation im oberen Bereich der Gräben (6) jeweils Isolationsstrukturen (8) erzeugt werden, die das Polysilizium im jeweiligen Graben (6) jeweils vollständig bedecken und die den Graben (6) seitlich überragen,

- bei dem nach Entfernen der $Si_3N_4$-Maske (5) unter Verwendung der Isolationsstruktur (8) als Ätzmaske jeweils zwischen benachbarten Gräben (6) ein Kontaktloch (9) geätzt wird, daß bis in die Wanne (3) hineinreicht,
- bei dem mindestens die Oberfläche der Kontaktlöcher (9) mit einer Metallisierung (13) zur Kontaktierung von Source und Wanne (3) versehen wird.

2. Verfahren nach Anspruch 1,
- bei dem in dem Substrat (1) als Drain ein erstes dotiertes Gebiet (11) von einem ersten Leitfähigkeitstyp erzeugt wird,
- bei dem oberhalb des ersten dotierten Gebietes (11) ein zweites dotiertes Gebiet (12) vom ersten Leitfähigkeitstyp erzeugt wird, das eine geringere Dotierstoffkonzentration aufweist als das erste dotierte Gebiet (11),
- bei dem durch Implantation unter Verwendung einer Maske (2) oberhalb des zweiten Gebietes (12) ein drittes Gebiet (3) erzeugt wird, das von einem zweiten, zum ersten entgegengesetzten Leitfähigkeitstyp dotiert ist und das die Wanne bildet,
- bei dem durch Implantation durch dieselbe Maske (2) oberhalb des dritten dotierten Gebietes 3) als Source ein viertes dotiertes Gebiet (4) vom ersten Leitfähigkeitstyp erzeugt wird, das eine größere Dotierstoffkonzentration als das zweite dotierte Gebiet (12) aufweist,
- bei dem die Gräben (6) bis in das zweite dotierte Gebiet (12) hineinreichen.

3. Verfahren nach Anspruch 2,
bei dem die Maske (2) für die Implantation aus $SiO_2$ gebildet wird.

4. Verfahren nach einem der Ansprüche 1 bis 3,
bei dem die Graben (6) Teil einer zusammenhängenden Grabenstruktur sind, in der im wesentlichen parallel zur Oberfläche des Substrats verlaufende Gräben mit quer dazu verlaufenden Gräben rasterförmig angeordnet sind und viereckige oder sechseckige Oberflächenelemente definieren.

5. Verfahren nach einem der Ansprüche 1 bis 4,
bei dem das Polysilizium in den Gräben (6) durch Abscheidung einer undotierten, konformen Polysiliziumschicht, die durch Ausdiffusion aus einer dotierten Phosphorglasschicht dotiert wird, und anschließendes Rückätzen der Polysiliziumschicht, wobei die Oberfläche der $Si_3N_4$-Maske (5) freigelegt wird, gebildet wird.

6. Verfahren nach Anspruch 5,
bei dem vor dem Rückätzen der Polysiliziumschicht eine Fotolackmaske erzeugt wird, die ein zusammenhängendes Flächenelement der Polysiliziumschicht abdeckt, das sich über mindestens zwei benachbarte Gräben (6) erstreckt.

7. Verfahren nach einem der Ansprüche 1 bis 6,
bei dem vor dem Aufbringen der Metallisierung (13) in die Oberfläche der Kontaktlöcher (9) Dotierstoff vom zweiten Leitfähigkeitstyp eingebracht wird.

8. Verfahren nach einem der Anspruch 1 bis 7,
bei dem die Kontaktlöcher (9) mit der Metallisierung (13) vollständig aufgefüllt werden.

9. Verfahren nach einem der Ansprüche 1 bis 8,
- bei dem das Draingebiet als vergrabene Schicht im Substrat erzeugt wird,
- bei dem seitlich von Source und Wanne ein tiefreichendes Anschlußgebiet zur Kontaktierung des Draingebietes von der Oberfläche des Substrats her gebildet wird.

10. Verfahren nach einem der Ansprüche 1 bis 9,
bei dem nach der Fertigstellung der Kontaktlöcher (9) zwischen benachbarten Gräben (6) in der Isolationsstruktur (8) ein weiteres Kontaktloch (10) zu dem Polysilizium in den Gräben (6) geöffnet wird.

FIG 1

FIG 2

FIG 3

FIG 4

FIG 5

FIG 6

FIG 7

FIG 8

FIG 9

91

93

92